(19) Europäisches Patentamt / European Patent Office / Office européen des brevets

(11) **EP 4 567 436 B1**

(12) **FASCICULE DE BREVET EUROPEEN**

(45) Date de publication et mention
de la délivrance du brevet:
**11.03.2026 Bulletin 2026/11**

(21) Numéro de dépôt: **24217222.9**

(22) Date de dépôt: **03.12.2024**

(51) Classification Internationale des Brevets (IPC):
**G01R 25/02** *(2006.01)* **G01R 27/04** *(2006.01)*

(52) Classification Coopérative des Brevets (CPC):
**G01R 27/04; G01R 25/02**

(54) **PROCÉDÉ ET APPAREIL DE MESURE DE LA PHASE D'UNE IMPÉDANCE COMPLEXE**

VERFAHREN UND VORRICHTUNG ZUM MESSEN DER PHASE EINER KOMPLEXEN IMPEDANZ

METHOD AND APPARATUS FOR MEASURING THE PHASE OF A COMPLEX IMPEDANCE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **07.12.2023 FR 2313794**

(43) Date de publication de la demande:
**11.06.2025 Bulletin 2025/24**

(73) Titulaire: **Commissariat à l'Energie Atomique et aux Energies Alternatives
75015 Paris (FR)**

(72) Inventeurs:
• **CABANILLAS, Esteban
38054 Grenoble Cedex 09 (FR)**
• **GARRAUD, Nicolas
38054 Grenoble Cedex 09 (FR)**

• **MARIANNE, Julien
38054 Grenoble Cedex 09 (FR)**

(74) Mandataire: **Atout PI Laplace
Immeuble Up On
25 Boulevard Romain Rolland
CS 40072
75685 Paris Cedex 14 (FR)**

(56) Documents cités:
**EP-A1- 3 792 640** **CN-A- 113 311 240**
**US-A1- 2020 150 164** **US-A1- 2023 305 071**

• **PANAGIOTIS KASSANOS ET AL: "A CMOS Magnitude/Phase Measurement Chip for Impedance Spectroscopy", IEEE SENSORS JOURNAL, IEEE, USA, vol. 13, no. 6, 1 June 2013 (2013-06-01), pages 2229 - 2236, XP011506442, ISSN: 1530-437X, DOI: 10.1109/ JSEN.2013.2251628**

**Description**

L'invention se situe dans le domaine de l'instrumentation électronique. Elle porte plus particulièrement sur un procédé et un appareil de mesure d'une impédance complexe d'un élément électrique.

La notion d'impédance complexe généralise celle de résistance pour des signaux sinusoïdaux à une fréquence f donné. Dans le cas d'un dipôle électrique, l'impédance complexe Z est définie par $Z = \dfrac{U}{I}$ où U est le phaseur (nombre complexe) représentant l'amplitude et la phase de la tension aux bornes du dipôle et I le phaseur représentant l'amplitude et la phase du courant le traversant. Plus généralement, dans le cas d'un circuit à N ports (le dipôle correspondant au cas N=1) on peut définir une impédance $Z_{ij} = \dfrac{U_i}{I_j}\Big|_{I_k=0, k \neq j}$. Autrement dit, l'impédance $Z_{ij}$ est le rapport (complexe) entre le phaseur représentant la tension aux borne du port « i » et le phaseur représentant le courant entrant dans (ou sortant de, en fonction de la convention adoptée) le port « j » lorsque le courant entrant dans tous les autres ports est nul. Les différents termes $Z_{ij}$ forment la matrice impédance de l'élément multiport. Dans la suite, le terme d'impédance et le symbole « Z » seront utilisés pour désigner tant l'impédance d'un dipôle qu'un terme $Z_{ij}$ de la matrice impédance d'un multiport.

Etant un nombre complexe, l'impédance Z peut se décomposer en une partie complexe et une partie imaginaire - Z=R+jX, où « j » désigne ici l'unité imaginaire - ou en module et en phase : $Z = |Z|e^{j\varphi}$, où |Z| est le rapport entre les valeurs efficaces de la tension et du courant et φ leur déphasage.

D'une manière générale, l'impédance varie avec la fréquence des signaux électriques considérés. Pour caractériser un élément électrique il est donc nécessaire de mesurer son (ou ses) impédance(s) dans une bande de fréquence plus ou moins étendue. On écrit donc Z(f), |Z(f)| et φ(f) pour désigner, respectivement, une impédance complexe, son module et sa phase en fonction de la fréquence f.

Plusieurs techniques ont été développées pour mesurer la phase d'une impédance, φ(f), en fonction de la fréquence.

Plusieurs méthodes connues de l'art antérieur permettent de mesurer la phase d'une impédance complexe.

(Angrisani 2001) divulgue un procédé de mesure dans lequel une résistance de valeur connue est connectée en série à l'élément à caractériser et un signal sinusoïdal d'excitation est appliqué audit élément à travers cette résistance. L'impédance de l'élément à caractériser peut être déterminée à partir de la mesure de la tension u(t) du signal d'excitation et de celle, v(t), d'un nœud situé entre la résistance connue et l'élément à caractériser. Plus particulièrement, deux méthodes sont proposées pour déterminer la phase de ladite impédance :

- Soit les passages par zéro des signaux u(t) et v(t) sont détectés, après avoir filtré ces deux signaux au moyen de filtres prédictifs à réponse impulsionnelle finie pour limiter l'impact du bruit sur la détection du zéro ;
- Soit le déphasage des deux signaux est calculée à partir de leur produit interne et de leur valeur quadratique moyenne.

(Schröder 2004) détermine aussi la phase d'une impédance complexe en mesurant le déphasage entre deux signaux de tension. Cette mesure de déphasage peut être réalisée par détection des passages par zéro desdits signaux, ou bien par calcul analytique à partir de paramètres d'amplitude et phase desdits signaux, déterminées par interpolation.

Les solutions proposées par (Schröder 2004) et (Angrisani 2001) mettent en œuvre une mesure de phase par comparateur de seuil ou passage à zéro qui nécessiter une électronique de mesure rapide, ce qui n'est pas compatible, par exemple, avec une solution à base de microcontrôleur, mais nécessite plutôt d'un ASIC ou un FPGA. Par ailleurs, la solution de (Angrisani 2001) nécessite la mise en œuvre d'un capteur de puissance spécifique et la réalisation de calculs assez complexes. Le document US 2020/150164 A1 présente aussi une approche pour la mesure de la phase d'une impédance complexe.

L'invention vise à surmonter au moins en partie les inconvénients précités de l'art antérieur. Plus spécifiquement, elle vise à permettre une mesure de la phase de l'impédance d'une élément électrique d'une manière particulièrement simple, mettant en œuvre un appareil de faible complexité, pouvant notamment être basé sur un microcontrôleur ou un FPGA.

Conformément à l'invention, ce but est atteint par un procédé dans lequel la phase de l'impédance d'un élément électrique est déterminée par un traitement numérique à partir d'un premier signal représentatif d'une tension entre deux bornes de l'élément électrique et un second signal représentatif d'un courant à travers l'élément électrique. Le traitement numérique implique la génération d'une réplique déphasée du premier ou du deuxième signal. Idéalement, le déphasage Φ de la réplique devrait être de 90° (ou, de manière équivalente, π/2 rad), ce qui peut être obtenu aisément à une fréquence donnée, mais nécessite une mise en œuvre complexe si on souhaite pouvoir effectuer un balayage de fréquence pour déterminer φ(f) sur une bande spectrale d'intérêt ayant une largeur significative (par exemple, une largeur de bande supérieure ou égale à 10% de la fréquence centrale de la bande)L'invention contourne cette difficulté en utilisant, au lieu d'un déphasage constant, un retard fixe. Ce retard correspond à un déphasage $\Phi$ de 90° seulement pour une fréquence $f_0$ appartenant à la bande d'intérêt, et à un déphasage de 90°+$\Delta\Phi(f)$ pour des fréquences différentes de $f_0$. Cela conduit à une erreur dans la mesure de $\varphi(f)|_{f\neq f_0}$. Une idée à la base de l'invention est que cette erreur peut être estimée et corrigée précisément au moyen d'une simple table de correspondance.

Un objet de l'invention est donc un procédé de mesure de la phase d'une impédance complexe d'un élément électrique comprenant les étapes suivantes :

a) appliquer audit élément électrique un signal d'excitation oscillant à une fréquence $f_{ex}$ connue ;
b) acquérir un premier signal analogique, variable au cours du temps, représentatif d'une tension entre deux bornes de l'élément électrique;
c) acquérir un second signal analogique, variable au cours du temps, représentatif d'un courant à travers l'élément électrique ;
d) échantillonner et convertir au format numérique le premier et le second signal analogique pour obtenir un premier et un deuxième signal numérique ;
e) générer une réplique, retardée d'un décalage temporel déterminé, dudit premier ou dudit deuxième signal numérique ;
f) calculer un troisième et un quatrième signal numérique, le troisième signal numérique étant obtenu soit en multipliant le premier signal numérique par la réplique retardée du deuxième signal numérique, soit en multipliant la réplique retardée du premier signal numérique par le deuxième signal numérique, et le quatrième signal numérique étant obtenu en multipliant le premier signal numérique par le deuxième signal numérique ;
g) appliquer un filtrage numérique passe-bas au troisième et au quatrième signal numérique ; et
h) déterminer ladite phase de l'impédance complexe de l'élément électrique en fonction d'un rapport entre le troisième et le quatrième signal numériques filtrés et de la fréquence $f_{ex}$ du signal d'excitation ;

l'étape h) étant mise en œuvre par application d'au moins une table de correspondance.
Selon des modes de réalisation particuliers d'un tel procédé :

-    Les étapes a) à h) peuvent être répétées une pluralité de fois pour une pluralité de fréquences $f_{ex}$ à l'intérieur d'une bande spectrale, le décalage temporel introduit lors de l'étape f) étant constant et égal à un quart d'une période correspondante à une fréquence incluse dans ladite bande spectrale.

-    Ladite bande spectrale peut présenter une largeur relative $\Delta f/fm$, où $\Delta f$ est l'écart entre la plus haute et la plus basse fréquence de la bande et fm sa fréquence moyenne, supérieure ou égale à 10%.

-    L'étape h) peut comprendre :

h1) la détermination d'une première valeur angulaire par calcul de l'arc-tangente dudit rapport entre le troisième et le quatrième signal numériques filtrés ; et
h2) la détermination de ladite phase de l'impédance complexe de l'élément électrique par application d'une table de correspondance à deux entrées, les entrées étant ladite première valeur angulaire et la fréquence $f_{ex}$ du signal d'excitation.

-    En variante, l'étape h) peut comprendre :

h1') le calcul d'une première valeur intermédiaire, somme dudit rapport entre le troisième et le quatrième signal numériques filtrés et d'un premier terme de correction obtenu à partir d'une première table de correspondance en fonction de la fréquence $f_{ex}$ du signal d'excitation ;
h2') le calcul d'une deuxième valeur intermédiaire, produit de la première valeur intermédiaire et d'un deuxième terme de correction obtenu à partir d'une deuxième table de correspondance en fonction de la fréquence $f_{ex}$ du signal d'excitation ; et
h'3) la détermination de ladite phase de l'impédance complexe de l'élément électrique par calcul de l'arc-tangente de ladite deuxième valeur intermédiaire.

-    Lors de l'étape d), le premier et le second signal analogique peuvent être échantillonnés et convertis au format numérique à une même cadence.

Un autre objet de l'invention est un appareil de mesure de la phase d'une impédance complexe d'un élément électrique comprenant :

- un premier convertisseur analogique - numérique configuré pour recevoir en entrée un premier signal analogique, variable au cours du temps, représentatif d'une tension entre deux bornes de l'élément électrique, et le convertir en un premier signal numérique ;
- un second convertisseur analogique - numérique configuré pour recevoir un second signal analogique, variable au cours du temps, représentatif d'un courant à travers l'élément électrique, et le convertir en un deuxième signal numérique ;
- une ligne de retard configurée pour générer une réplique, retardée d'un décalage temporel déterminé, dudit premier ou dudit deuxième signal numérique ; et
- un circuit numérique configuré pour :

  - calculer un troisième et un quatrième signal numérique, le troisième signal numérique étant obtenu soit en multipliant le premier signal numérique par la réplique retardée du deuxième signal numérique, soit en multipliant la réplique retardée du premier signal numérique par le deuxième signal numérique, et le quatrième signal numérique étant obtenu en multipliant le premier signal numérique par le deuxième signal numérique ;
  - appliquer un filtrage numérique passe-bas au troisième et au quatrième signal numérique ; et
  - déterminer ladite phase de l'impédance complexe de l'élément électrique en fonction d'un rapport entre le troisième et le quatrième signal numériques filtrés et de la fréquence fex du signal d'excitation par application d'au moins une table de correspondance.

Selon des modes de réalisation particuliers :

- L'appareil peut comprendre également un générateur d'un signal d'excitation oscillant présentant une fréquence d'oscillation variable de manière contrôlée à l'intérieur d'une bande spectrale, ladite ligne de retard étant configurée pour introduire un décalage temporel constant et égal à un quart d'une période correspondante à une fréquence incluse dans ladite bande spectrale.

- Ladite bande spectrale peut présenter une largeur relative $\Delta f/f_m$, où $\Delta f$ est l'écart entre la plus haute et la plus basse fréquence de la bande et $f_m$ sa fréquence moyenne, comprise supérieure ou égale à 10%.

- Le circuit numérique peut être configuré pour :

  - déterminer une première valeur angulaire par calcul de l'arc-tangente dudit rapport entre le troisième et le quatrième signal numériques filtrés ; et
  - déterminer ladite phase de l'impédance complexe de l'élément électrique par application d'une table de correspondance à deux entrées, les entrées étant ladite première valeur angulaire et la fréquence fex du signal d'excitation.

- En variante, le circuit numérique peut être configuré pour :

  - calculer une première valeur intermédiaire, somme dudit rapport entre le troisième et le quatrième signal numériques filtrés et d'un premier terme de correction obtenu à partir d'une première table de correspondance en fonction de la fréquence fex du signal d'excitation ;
  - calculer une deuxième valeur intermédiaire, produit de la première valeur intermédiaire et d'un deuxième terme de correction obtenu à partir d'une deuxième table de correspondance en fonction de la fréquence fex du signal d'excitation ; et
  - déterminer ladite phase de l'impédance complexe de l'élément électrique par calcul de l'arc-tangente de ladite deuxième valeur intermédiaire.

- L'appareil peut comprendre également une horloge configurée pour cadencer lesdits premier et second convertisseurs analogique - numérique à une même cadence d'acquisition et conversion desdits premier et second signaux analogiques.

D'autres caractéristiques, détails et avantages de l'invention ressortiront à la lecture de la description faite en référence aux dessins annexés donnés à titre d'exemple et qui représentent, respectivement :

[Fig.1], le schéma fonctionnel d'un appareil de mesure selon un premier mode de réalisation de l'invention ;

[Fig. 2], [Fig. 3] et [Fig. 4] des graphiques illustrant l'erreur de déphasage provoqué par l'utilisation d'un retard fixe pour des signaux de fréquence différente ;

[Fig. 5], la structure d'une table de correspondance utilisée par le dispositif de la [Fig. 1] ;

[Fig.6], le schéma fonctionnel d'un dispositif selon un second mode de réalisation de l'invention ; et

[Fig. 7], le schéma fonctionnel d'un dispositif ne relevant pas de l'invention.

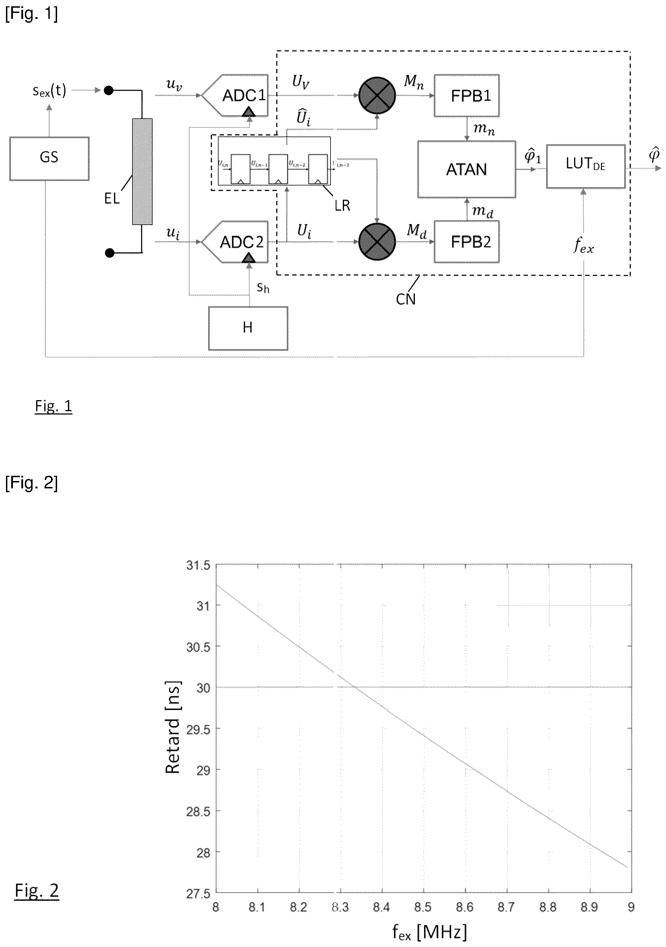

Sur la [Fig. 1], la référence EL représente un élément électrique (plus particulièrement, un dipôle, comprenant deux bornes formant un seul port) dont la phase de l'impédance complexe doit être déterminée. Un générateur GS applique un signal d'excitation $s_{ext}(t)$ sinusoïdal, de fréquence $f_{ex}$ variable, aux bornes de l'élément EL. Le signal EL peut être un signal de courant ou de tension. Le générateur GS fournit également à sa sorte une valeur numérique représentative de la fréquence $f_{ex}$. Le générateur GS peut, par exemple, être piloté de telle sorte que $f_{ex}$ balaye, de manière continue ou discrète, une bande spectrale d'intérêt.

L'appareil de la [Fig. 1] reçoit sur un premier port d'entré un premier signal analogique $u_v(t)$ représentatif de la tension aux bornes de l'élément EL et sur un deuxième port d'entré un second signal analogique $u_i(t)$ représentatif du courant traversant ce dernier. Par exemple, le signal $u_v(t)$ peut être directement la tension aux bornes de l'élément EL et $u_i(t)$ une tension aux bornes d'une résistance connectée en série à EL. Un premier convertisseur analogique - numérique ADC1 échantillonne et convertit le signal analogique $u_v$ en un signal numérique $U_v$. De même, un second convertisseur analogique - numérique ADC2 échantillonne convertit le signal analogique $u_i$ en un signal numérique $U_i$. Ces deux signaux numériques sont fournis en entrée à un circuit numérique de traitement CN, avec la valeur $f_{ex}$ de la fréquence du signal d'excitation. L'appareil comprend également une horloge H qui fournit un signal de cadencement $s_h$ commun aux deux convertisseurs analogique - numérique, définissant une période d'échantillonnage $T_h$.

Le circuit numérique CN comprend une ligne de retard LR qui génère une réplique $\hat{U}_i$ du signal numérique $U_i$, retardée d'un retard T connu. Dans le mode de réalisation de la [Fig. 1], la ligne de retard est constituée d'un nombre N de bascules cadencées de manière synchrone aux convertisseurs ADC1 et ADC2 par le signal de cadencement $s_h$. Le retard T vaut donc $N/f_h$, où $f_h = 1/T_h$ est la fréquence fondamentale du signal $s_h$. Le signal $\hat{U}_i$ est déphasé, par rapport à $U_i$, d'une

phase    $\Phi = 2\pi T f_{ex} \, \text{rad} = 2\pi N \frac{f_{ex}}{f_h} \, \text{rad} = \left(360 \cdot N \frac{f_{ex}}{f_h}\right)^{\circ}$ .  Aussi, pour une fréquence d'excitation

$f_{ex} = f_0 = \frac{f_h}{4\,N}$ , le déphasage vaut 90° (ou $\pi/2$ rad).

On considère un signal d'excitation à la fréquence $f_{ex} = f_0$. Les deux signaux numérisés $U_v$ et $U_i$ peuvent s'écrire :

$$U_V = cos(\beta_0)$$

$$U_i = cos(\beta_1)$$

avec

$$\beta_0 = \omega_0 t + \varphi_0 \text{ et } \beta_1 = \omega_0 t + \varphi_0 + \varphi_1$$

où Dans les équations précédentes, $\omega_0 = 2\pi f_0$ est la pulsation du signal d'excitation, $\varphi_0$ est une phase commune à la tension et au courant et $\varphi_1$ est le déphasage du courant par rapport à la fonction tension. La phase de l'impédance complexe Z de l'élément EL est donnée par $\varphi = -\varphi_1$. Dans les équations qui précèdent, l'amplitude des signaux $U_v$ et $U_i$ a été normalisée à 1, mais la démarche est similaire pour des signaux non normalisés.

Comme expliqué plus haut, pour $f_{ex} = f_0$ la ligne de retard LR introduit un déphasage de $\pi/2$ rad. Par conséquent :

$$\hat{U}_i = cos\left(\beta_1 + {}^{\pi}/_2\right) = sin(\beta_1)$$

Le circuit numérique CN calcule donc le produit du premier signal numérique $U_i$ et de la réplique retardée du deuxième signal numérique, $\hat{U}_i$, pour générer un troisième signal numérique $M_n$. Il calcule également le produit du premier signal numérique $U_i$ et du deuxième signal numérique (sans déphasage) $U_i$ pour générer un quatrième signal numérique

$M_d$ :

$$M_n = U_V \widehat{U}_i = 2sin(\beta_1)cos(\beta_0) = \frac{1}{2}[sin(\beta_1 + \beta_0) + sin(\beta_1 - \beta_0)] =$$

$$\frac{1}{2}sin(2\omega_0 t + 2\varphi_0 + \varphi_1) + \frac{1}{2}sin(\varphi_1)$$

et

$$M_d = U_V U_i = cos(\beta_1)cos(\beta_0)\frac{1}{2}[cos(\beta_1 + \beta_0) + cos(\beta_1 - \beta_0)] =$$

$$\frac{1}{2}cos(2\omega_0 t + 2\varphi_0 + \varphi_1) + \frac{1}{2}cos(\varphi_1)$$

Le troisième et le quatrième signal numérique comprennent tous deux une composante oscillante à la fréquence $2f_0$ (termes en $2\omega_0 t$) et une composante continue. Ces signaux sont filtrés par des filtres passe-bas numériques FPB1, FPB2 pour récupérer les composantes continues. Les signaux filtrés sont exprimés par (en négligeant le facteur d'amplitude $\frac{1}{2}$ ) :

$$m_n = sin(\beta_1 - \beta_0) = sin(\varphi_1)$$

$$m_d = cos(\beta_1 - \beta_0) = cos(\varphi_1)$$

Une estimation $\hat{\varphi}_1$ de la valeur de $\varphi_1$ est obtenue en calculant l'arc-tangente du rapport du troisième signal numérique filtré et du quatrième signal numérique filtré :

$$\hat{\varphi}_1 = atan\left(\frac{m_n}{m_d}\right)$$

Lorsque $f_{ex} \neq f_0$, cependant, $\hat{\varphi}_1$ n'est plus une bonne estimation de $\varphi_1$, et donc de la phase de l'impédance complexe de EL, car le déphasage introduit par la ligne de retard LR ne vaut plus 90°

On considère par exemple un cas où $f_h$ = 100 MHz (période d'échantillonnage de $T_H$ = 10 ns) et la bande de fréquence d'intérêt est comprise entre 8 MHz à 9 MHz, échantillonnée avec un pas de 1 MHz. Dans cette plage de fréquence, un retard correspondant à un déphasage de 90° irait de 31,25 ns à 27,77 ns. On choisit alors de réaliser la ligne de retard LR au moyen de trois bascules cadencées à la fréquence $f_h$ de 100 MHz, introduisant donc un retard constant de 30 ns. Ce retard correspond à un déphasage de 90° pour un signal d'excitation à 8.33 MHz. La [Fig. 2] illustre la variation du retard optimal (c'est-à-dire correspondant à un déphasage de 90°) en fonction de la fréquence $f_{ex}$.

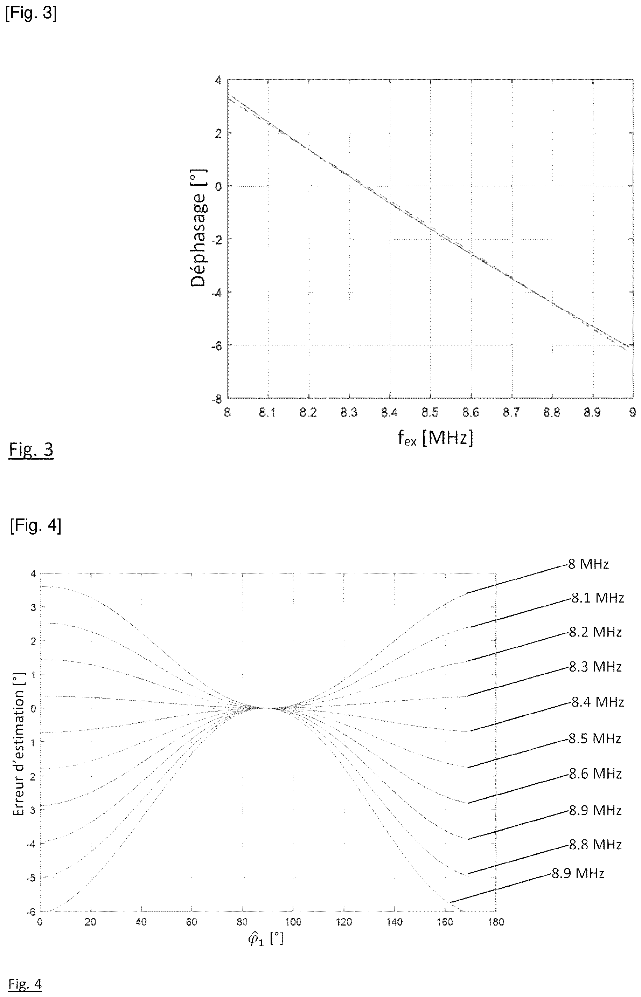

Pour des signaux à une fréquence $f_{ex} \neq f_0$ = 8,33 *MHz,* le déphasage $\Phi$ prend une valeur différente de 90°. On pose $\Phi(f_{ex})$=90°+$\Delta\Phi$, où $\Delta\Phi$ est l'erreur de déphasage. La [Fig. 3] illustre la variation de $\Delta\Phi$ en fonction de la fréquence. On constate que l'erreur peut atteindre 6° pour $f_{ex}$=9 MHz. Sur cette figure, le trait tireté montre une approximation linéaire de $\Delta\Phi(f)$, qui peut être utilisée à la place de la valeur exacte pour simplifier les calculs.

Avec un déphasage générique $\Phi$=90°+$\Delta\Phi$ (ou, en radians, $\Phi=\pi/2+\Delta\Phi$), la réplique retardée du deuxième signal numérique peut s'écrire

$$\widehat{U}_i = cos(\beta_1 + {}^\pi/_2 + \Delta\Phi) = sin(\beta_1 + \Delta\Phi)$$

En appliquant la même méthode que pour le cas $\Phi$=90° on trouve :

$$\widehat{\varphi}_1 = atan\left(\frac{m_n}{m_d}\right) = atan\left(\frac{sin(\varphi_1)cos(\Delta\Phi)+cos(\varphi_1)sin(\Delta\Phi)}{cos(\varphi_1)}\right) \neq \varphi_1$$

**EP 4 567 436 B1**

Il est possible d'écrire $\hat{\varphi}_1 = \varphi_1 + \Delta\varphi_1$, où $\Delta\varphi_1$ est une erreur d'estimation. qui dépend à la fois de l'estimation initiale $\hat{\varphi}_1$ et de la fréquence $f_{ex}$. Par exemple, la [Fig. 4] illustre la variation de $\Delta\varphi_1$ en fonction de $\hat{\varphi}_1$ pour différentes valeurs de la fréquence $f_{ex}$ dans la plage [8 MHz ; 9 MHz].

Or, l'équation ci-dessus permet de calculer cette erreur d'estimation, et donc de la corriger par ajout d'un terme correctif : $\varphi_1 = \hat{\varphi}_1 + \Phi_{cmp}$ avec $\Phi_{cmp} = -\Delta\varphi_1$. Concrètement, la bande spectrale d'intérêt est discrétisée en N-1 intervalles $F0=[f_0 ; f_1)$, $F1=[f_0 ; f_1)$, ... $FN-1=[f_{N-1} ; f_N]$ ; de même, la plage angulaire (-180° ; 180°] est discrétisée en M-1 intervalles

$$\left(\Phi 0 = (\hat{\varphi}_1^0 = -180°; \; \hat{\varphi}_1^1], ... \Phi M - 1(\hat{\varphi}_1^{M-1}; \; \hat{\varphi}_1^M]\right.$$ . Une valeur discrète du terme correctif $\Phi_{cmp(i,j)}$ est calculée pour chaque couple (Fi, Φj) de manière à former une table de correspondance à double entrée $LUT_{DE}$. A chaque fois qu'une nouvelle phase $\hat{\varphi}_1$ est estimée, le circuit numérique CN identifie l'intervalle Φj la contenant, ainsi que l'intervalle Fi contenant la fréquence d'excitation $f_{ex}$, extrait de la table de correspondance le terme correctif $\Phi_{cmp(i,j)}$ correspondant et l'additionne à $\hat{\varphi}_1$ pour trouver une meilleure estimation $\hat{\varphi}$ de la phase de l'impédance complexe de l'élément EL.

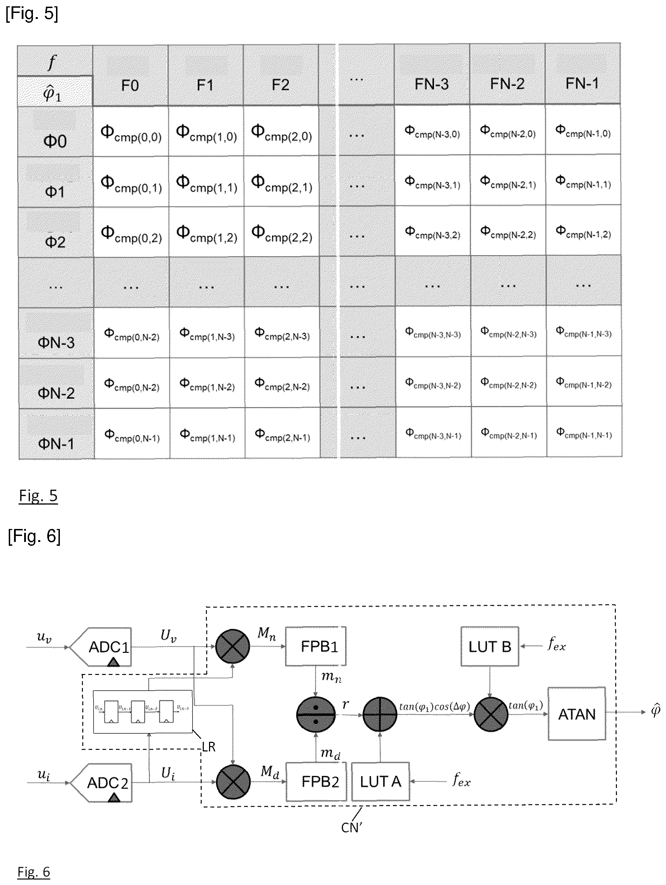

Pour réduire l'occupation de mémoire de la table de correspondance à double entrée $LUT_{DE}$ il est possible de la remplacer par deux tables de correspondance à une seule entrée, comme dans le mode de réalisation de la [Fig. 6], qui comporte un circuit numérique modifié CN'. Dans ce circuit numérique, les signaux numériques en sortie des filtres passebas FPB1, FPB2

$$m_n = \sin(\beta_1 + \Delta\Phi - \beta_0) = \sin(\varphi_1 + \Delta\Phi) = \sin(\varphi_1)\cos(\Delta\Phi) + \cos(\varphi_1)\sin(\Delta\Phi)$$

$$m_d = \cos(\beta_1 - \beta_0) = \cos(\varphi_1)$$

Sont fournis en entrée à un bloc diviseur qui calcule leur rapport

$$r = \frac{m_n}{m_d} = \frac{\sin(\varphi_1)\cos(\Delta\Phi)+\cos(\varphi_1)\sin(\Delta\Phi)}{\cos(\varphi_1)} = \tan(\varphi_1)\cos(\Delta\Phi) + \sin(\Delta\varphi)$$

L'ajout d'un premier terme correctif égal à $-sin(\Delta\Phi)$ issu d'une première table de correspondance LUTA permet d'obtenir une première valeur intermédiaire égale à $tan(\varphi_1)\cos(\Delta\Phi)$. Cette dernière est multipliée par un deuxième terme correcteur égal à $\frac{1}{\cos(\Delta\Phi)}$, issu d'une deuxième table de correspondance LUTB, de manière à obtenir une deuxième valeur intermédiaire égale à $tan(\varphi_1)$. Le calcul de l'arc-tangente de cette deuxième valeur intermédiaire fournit l'estimation attendue estimation $\hat{\varphi}$ de la phase de l'impédance complexe de l'élément EL.

Les deux termes correcteurs dépendent uniquement de $\Delta\Phi$, qui à son tour est uniquement fonction de la fréquence d'excitation $f_{ex}$. Par conséquent, les deux tables de correspondance LUTA et LUTB peuvent être à une seule entrée (autrement dit, des vecteurs de valeurs) et recevoir en entrée une valeur représentative de ladite fréquence.

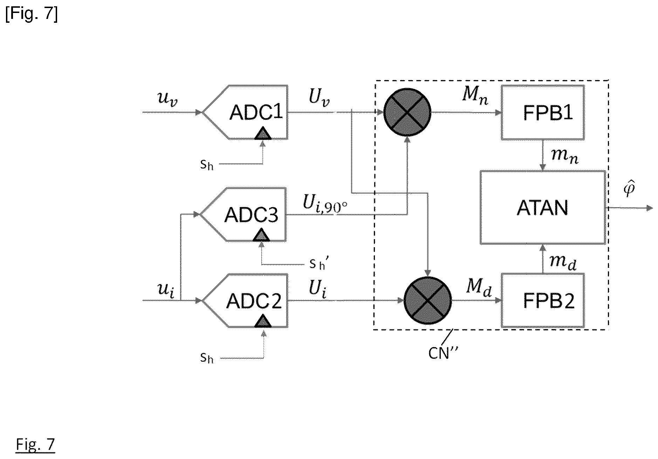

La [Fig. 7] illustre un appareil de mesure de la phase d'une impédance complexe qui ne relève pas de l'invention. Ce dispositif comporte un troisième convertisseur analogique - numérique ADC3, recevant en entrée le second signal analogique $u_i$ et cadencé par un signal d'horloge $s_h$' différent de celui, $s_h$, utilisé par les deux autres convertisseurs, ADC1 et ADC2. Ce signal d'horloge $s_h$', généré par exemple par une PLL (boucle à verrouillage de phase) à partir de $s_h$, présente la même fréquence que ce dernier, mais une phase différente et adaptée à $f_{ex}$ de manière à générer une réplique du deuxième signal numérique $U_i$ déphasée de 90°, $U_{i,90°}$. Dans ces conditions, le circuit numérique CN" n'a pas besoin de mettre en oeuvre des tables de correspondance pour corriger l'estimation de phase issue du bloc de calcul de la fonction arc-tangente.

Cette solution n'est pas préférée en raison de la nécessité d'un convertisseur analogique-numérique supplémentaire et d'une PLL, ce qui augmente sa complexité, son coût et sa consommation électrique. Une complexité additionnel vient du fait que les convertisseurs ADC2 et ADC3 doivent avoir des performances très proches en termes de linéarité et de gain, sous peine d'introduire des erreurs importantes. Par ailleurs, la PLL qui génère $s_h$' nécessite un temps relativement important (plusieurs dizaines de $\mu$s) pour se stabiliser sur une nouvelle phase, ce qui ralentit la cadence d'acquisition des mesures.

Quel que soit le mode de réalisation considéré, le circuit numérique CN, CN' peut comprendre un microprocesseur, auquel cas certaines ou toutes les fonctionnalités du circuit sont réalisées de manière logicielle, ou des circuits logiques basés, par exemple, sur un FPGA. En particulier, la « ligne de retard » LR peut être réalisée à partir de bascules ou bien être émulée par des instructions logicielles Les tables de correspondance $LUT_{DE}$, LUTA, LUTB peuvent être stockées dans dispositifs de mémoire dédiés ou dans des emplacements spécifiques d'une mémoire unique.. On remarquera par ailleurs que le calcul de l'arc-tangente peut être réalisé au moyen d'une table de correspondance.

L'invention a été décrite en référence à des modes de réalisation particulier, mais des variantes sont possibles. Par exemple :

- La ligne de retard LR est utilisée pour générer une réplique retardée du premier signal numérique $U_v$, au lieu d'une réplique retardée du deuxième signal numérique $U_i$ comme décrit plus haut.

- Les convertisseurs numérique - analogique ADC1, ADC2 peuvent ne pas être cadencés par un même signal d'horloge, pourvu qu'une resynchronisation soit effectuée lors du traitement numérique.

- La discrétisation de la bande spectrale d'intérêt et/ou celle de la plage angulaire (-180° ; 180°] pour la mise en œuvre de la ou des tables de correspondance peut ne pas être uniforme afin de minimiser l'erreur maximale résiduelle après application du ou des termes correctifs.

- Il est également possible de modifier la fréquence du signal d'horloge $s_h$ au moyen d'une PLL en fonction de la fréquence $f_{ex}$ de manière à réduire l'erreur de déphasage de la réplique $\hat{U}_i$. Cela permet de simplifier la correction d'erreur d'estimation de la phase de l'impédance complexe - par exemple en autorisant le recours à une discrétisation plus grossière de la bande spectrale et/ou des de la plage angulaire (-180° ; 180°], et en réduisant ainsi la taille de la ou des tables de correspondance. Mais cette simplification se paie par l'utilisation d'une PLL avec les inconvénients associés (ralentissement, augmentation du coût et de la complexité).

Références

(Angrisani 2001): L. Angrisani, L. Ferrigno, Reducing the uncertainty in real-time impedance measurements, Measurement, Volume 30, Issue 4, 2001, Pages 307-315,

(Schröder 2004): Jens Schröder and Steffen Doerner and Thomas Schneider and Peter Hauptmann, Analogue and digital sensor interfaces for impedance spectroscopy, Measurement Science and Technology, Volume 15, Issue 7, 2004, Pages 1271 - 1278

**Revendications**

1. Procédé de mesure de la phase d'une impédance complexe d'un élément électrique (EL) comprenant les étapes suivantes :

   a) appliquer audit élément électrique (EL) un signal d'excitation ($s_{ex}$) oscillant à une fréquence $f_{ex}$ connue ;
   b) acquérir un premier signal analogique ($u_v$), variable au cours du temps, représentatif d'une tension entre deux bornes de l'élément électrique;
   c) acquérir un second signal analogique ($u_i$), variable au cours du temps, représentatif d'un courant à travers l'élément électrique ;
   d) échantillonner et convertir au format numérique le premier et le second signal analogique pour obtenir un premier ($U_v$) et un deuxième ($U_i$) signal numérique ;
   e) générer une réplique ($\hat{U}_i$), retardée d'un décalage temporel déterminé, dudit premier ou dudit deuxième signal numérique ; **caractérisé en ce que** ledit procédé comprend les étapes suivantes :
   f) calculer un troisième ($M_n$) et un quatrième ($M_d$) signal numérique, le troisième signal numérique étant obtenu soit en multipliant le premier signal numérique par la réplique retardée du deuxième signal numérique, soit en multipliant la réplique retardée du premier signal numérique par le deuxième signal numérique, et le quatrième signal numérique étant obtenu en multipliant le premier signal numérique par le deuxième signal numérique ;
   g) appliquer un filtrage numérique passe-bas (FPB1, FPB2) au troisième et au quatrième signal numérique ; et
   h) déterminer ladite phase ($\hat{\varphi}$) de l'impédance complexe de l'élément électrique en fonction d'un rapport entre le troisième ($m_n$) et le quatrième ($m_d$) signal numériques filtrés et de la fréquence $f_{ex}$ du signal d'excitation ;

   l'étape h) étant mise en œuvre par application d'au moins une table de correspondance ($LUT_{DE}$, LUTA, LUTB).

2. Procédé selon la revendication 1 dans lequel les étapes a) à h) sont répétées une pluralité de fois pour une pluralité de

fréquences $f_{ex}$ à l'intérieur d'une bande spectrale, le décalage temporel introduit lors de l'étape f) étant constant et égal à un quart d'une période correspondante à une fréquence incluse dans ladite bande spectrale.

3. Procédé selon l'une des revendications précédentes dans lequel ladite bande spectrale présente une largeur relative $\Delta f/f_m$, où $\Delta f$ est l'écart entre la plus haute et la plus basse fréquence de la bande et $f_m$ sa fréquence moyenne, supérieure ou égale à 10%.

4. Procédé selon l'une des revendications précédentes dans lequel l'étape h) comprend :

   h1) la détermination d'une première valeur angulaire ($\hat{\varphi}_1$) par calcul de l'arc-tangente dudit rapport entre le troisième et le quatrième signal numériques filtrés ; et
   h2) la détermination de ladite phase de l'impédance complexe de l'élément électrique par application d'une table de correspondance à deux entrées ($LUT_{DE}$), les entrées étant ladite première valeur angulaire et la fréquence $f_{ex}$ du signal d'excitation.

5. Procédé selon l'une des revendications 1 à 3 précédentes dans lequel l'étape h) comprend :

   h1') le calcul d'une première valeur intermédiaire, somme dudit rapport entre le troisième et le quatrième signal numériques filtrés et d'un premier terme de correction obtenu à partir d'une première table de correspondance (LUTA) en fonction de la fréquence $f_{ex}$ du signal d'excitation ;
   h2') le calcul d'une deuxième valeur intermédiaire, produit de la première valeur intermédiaire et d'un deuxième terme de correction obtenu à partir d'une deuxième table de correspondance (LUTB) en fonction de la fréquence $f_{ex}$ du signal d'excitation ; et
   h'3) la détermination de ladite phase de l'impédance complexe de l'élément électrique par calcul de l'arc-tangente de ladite deuxième valeur intermédiaire.

6. Procédé selon l'une des revendications précédentes dans lequel, lors de l'étape d), le premier et le second signal analogique sont échantillonnés et convertis au format numérique à une même cadence.

7. Appareil de mesure de la phase d'une impédance complexe d'un élément électrique (EL) comprenant :

   - un premier convertisseur analogique - numérique (ADC1) configuré pour recevoir en entrée un premier signal analogique ($u_v$), variable au cours du temps, représentatif d'une tension entre deux bornes de l'élément électrique, et le convertir en un premier signal numérique ($U_v$) ;
   - un second convertisseur analogique - numérique (ADC2) configuré pour recevoir un second signal analogique ($u_i$), variable au cours du temps, représentatif d'un courant à travers l'élément électrique, et le convertir en un deuxième signal numérique ($U_v$) ;
   - une ligne de retard (LR) configurée pour générer une réplique ($\hat{U}_i$), retardée d'un décalage temporel déterminé, dudit premier ou dudit deuxième signal numérique ; caractérisé en ce ledit appareil de mesure comprend
   - un circuit numérique configuré pour :

      - calculer un troisième ($M_n$) et un quatrième ($M_d$) signal numérique, le troisième signal numérique étant obtenu soit en multipliant le premier signal numérique par la réplique retardée du deuxième signal numérique, soit en multipliant la réplique retardée du premier signal numérique par le deuxième signal numérique, et le quatrième signal numérique étant obtenu en multipliant le premier signal numérique par le deuxième signal numérique ;
      - appliquer un filtrage numérique passe-bas (FPB1, FPB2) au troisième et au quatrième signal numérique ; et
      - déterminer ladite phase ($\hat{\varphi}$) de l'impédance complexe de l'élément électrique en fonction d'un rapport entre le troisième ($m_n$) et le quatrième (md) signal numériques filtrés et de la fréquence $f_{ex}$ du signal d'excitation par application d'au moins une table de correspondance ($LUT_{DE}$, LUTA, LUTB).

8. Appareil selon la revendication 7 comprenant également un générateur (GS) d'un signal d'excitation ($s_{ex}$) oscillant présentant une fréquence d'oscillation $f_{ex}$ variable de manière contrôlée à l'intérieur d'une bande spectrale, dans lequel ladite ligne de retard (LR) est configurée pour introduire un décalage temporel constant et égal à un quart d'une période correspondante à une fréquence incluse dans ladite bande spectrale.

9. Appareil selon la revendication 8 dans lequel ladite bande spectrale présente une largeur relative $\Delta f/f_m$, où $\Delta f$ est l'écart entre la plus haute et la plus basse fréquence de la bande et $f_m$ sa fréquence moyenne, comprise supérieure ou égale à 10%.

10. Appareil selon l'une des revendications 7 à 9 dans lequel le circuit numérique est configuré pour :

- déterminer une première valeur angulaire ($\hat{\varphi}_1$) par calcul de l'arc-tangente dudit rapport entre le troisième et le quatrième signal numériques filtrés ; et
- déterminer ladite phase de l'impédance complexe de l'élément électrique par application d'une table de correspondance à deux entrées (LUT$_{DE}$), les entrées étant ladite première valeur angulaire et la fréquence $f_{ex}$ du signal d'excitation.

11. Appareil selon l'une des revendications 7 à 9 dans lequel le circuit numérique est configuré pour :

- calculer une première valeur intermédiaire, somme dudit rapport entre le troisième et le quatrième signal numériques filtrés et d'un premier terme de correction obtenu à partir d'une première table de correspondance (LUTA) en fonction de la fréquence $f_{ex}$ du signal d'excitation ;
- calculer une deuxième valeur intermédiaire, produit de la première valeur intermédiaire et d'un deuxième terme de correction obtenu à partir d'une deuxième table de correspondance (LUTB) en fonction de la fréquence $f_{ex}$ du signal d'excitation ; et
- déterminer ladite phase de l'impédance complexe de l'élément électrique par calcul de l'arc-tangente de ladite deuxième valeur intermédiaire.

12. Appareil selon l'une des revendications 7 à 9 comprenant également une horloge (H) configurée pour cadencer lesdits premier et second convertisseurs analogique - numérique à une même cadence d'acquisition et conversion desdits premier et second signaux analogiques.

**Patentansprüche**

1. Verfahren zum Messen der Phase einer komplexen Impedanz eines elektrischen Elements (EL), die folgenden Schritte umfassend:

a) Anwenden auf das elektrisches Element (EL) eines Anregungssignals ($S_{ex}$), das mit einer bekannten Frequenz $f_{ex}$ oszilliert;
b) Erfassen eines ersten sich mit der Zeit ändernden analogen Signals ($u_v$), das repräsentativ für eine Spannung zwischen zwei Klemmen des elektrischen Elements ist;
c) Erfassen eines zweiten sich mit der Zeit ändernden analogen Signals ($u_i$), das repräsentativ für einen Strom durch das elektrische Element hindurch ist;
d) Beproben und Umwandeln in das digitale Format des ersten und des zweiten analogen Formats, um ein erstes ($U_v$) und ein zweites ($U_i$) digitales Signal zu erhalten;
e) Erzeugen einer um eine bestimmte Zeitverzögerung verspäteten Nachbildung ($\hat{U}_i$) des ersten oder des zweiten digitalen Signals; **dadurch gekennzeichnet, dass** das Verfahren die folgenden Schritte umfasst:
f) Berechnen eines dritten ($M_n$) und eines vierten ($M_d$) digitalen Signals, wobei das dritte digitale Signal entweder durch Multiplizieren des ersten digitalen Signals mit der verspäteten Nachbildung des zweiten digitalen Signals, oder durch Multiplizieren der verspäteten Nachbildung des ersten digitalen Signals mit dem zweiten digitalen Signal erhalten wird, und das vierte digitale Signal durch Multiplizieren des ersten digitalen Signals mit dem zweiten digitalen Signal erhalten wird;
g) Anwenden einer digitalen Tiefpassfilterung (FPB1, FPB2) auf das dritte und auf das vierte digitale Signal; und
h) Bestimmen der Phase ($\hat{\varphi}$) der komplexen Impedanz des elektrischen Elements in Abhängigkeit von einem Verhältnis zwischen dem dritten ($m_n$) und dem vierten ($m_d$) gefilterten digitalen Signal und der Frequenz $f_{ex}$ des Anregungssignals;

wobei der Schritt h) durch Anwenden mindestens einer Nachschlagstabelle (LUT$_{DE}$, LUTA, LUTB) umgesetzt wird.

2. Verfahren nach Anspruch 1 wobei die Schritte a) bis h) eine Vielzahl von Malen für eine Vielzahl von Frequenzen $f_{ex}$ im Inneren eines Spektralbandes wiederholt werden, wobei die Zeitverzögerung, die im Schritt f) eingesetzt wird, konstant und gleich einem Viertel eines entsprechenden Zeitraums mit einer Frequenz ist, die im Spektralband beinhaltet ist.

3. Verfahren nach einem der vorstehenden Ansprüche, wobei das Spektralband eine relative Breite $\Delta f/f_m$ aufweist, wobei $\Delta f$ die Abweichung zwischen der höchsten und der niedrigsten Frequenz des Bandes ist, und $f_m$ seine mittlere Frequenz, größer oder gleich 10% ist.

4. Verfahren nach einem der vorstehenden Ansprüche, wobei der Schritt h) umfasst:

   h1) die Bestimmung eines ersten Winkelwertes ($\hat{\phi}_1$) durch Berechnen der Bogentangente des Verhältnisses zwischen dem dritten und vierten gefilterten digitalen Wert ist; und
   h2) die Bestimmung der Phase der komplexen Impedanz des elektrischen Elements durch Anwenden einer zweieingängigen Nachschlagstabelle ($LUT_{DE}$), wobei die Eingänge der erste Winkelwert und die Frequenz $f_{ex}$ des Anregungssignals sind.

5. Verfahren nach einem der Ansprüche 1 bis 3, wobei der Schritt h) umfasst:

   h1') die Berechnung eines ersten Zwischenwerts, Summe des Verhältnisses zwischen dem dritten und vierten gefilterten digitalen Signals und eines ersten Korrekturbegriffs, der aus einer ersten Nachschlagstabelle (LUTA) in Abhängigkeit von der Frequenz $f_{ex}$ des Anregungssignals erhalten wird;
   h2') die Berechnung eines zweiten Zwischenwerts, Produkt des ersten Zwischenwerts und eines zweiten Korrekturbegriffs, der aus einer zweiten Nachschlagstabelle (LUTB) in Abhängigkeit von der Frequenz $f_{ex}$ des Anregungssignals erhalten wird; und
   h'3) die Bestimmung der Phase der komplexen Impedanz des elektrischen Elements durch Berechnen der Bogentangente des zweiten Zwischenwerts.

6. Verfahren nach einem der vorstehenden Ansprüche, wobei im Schritt d) das erste und das zweite analoge Signal mit einem gleichen Takt beprobt und in das digitalen Format umgewandelt werden.

7. Einrichtung zum Messen der Phase einer komplexen Impedanz eines elektrischen Elements (EL), umfassend:

   - einen ersten Analog-Digital-Wandler (ADC1), der konfiguriert ist, um als Eingang ein erstes sich mit der Zeit änderndes analoges Signal ($u_v$) zu empfangen, das repräsentativ für eine Spannung zwischen zwei Klemmen des elektrischen Elements ist, und es in ein erstes digitales Signal ($U_v$) umzuwandeln;
   - einen zweiten Analog-Digital-Wandler (ADC2), der konfiguriert ist, um ein zweites sich mit der Zeit änderndes analoges Signal ($u_i$) zu empfangen, das repräsentativ für einen Strom durch das elektrische Element hindurch, und es in ein zweites digitales Signal ($U_v$) umzuwandeln;
   - eine Verzögerungsleitung (LR), die so konfiguriert ist, dass sie eine um eine bestimmte Zeitverzögerung verspäteten Nachbildung ($\hat{U}_i$) des ersten oder des zweiten digitalen Signals erzeugt; **dadurch gekennzeichnet, dass** die Vorrichtung zum Messen umfasst:
   - eine digitale Schaltung, die konfiguriert ist, um:

      - ein drittes ($M_n$) und ein viertes ($M_d$) digitales Signal zu berechnen, wobei das dritte digitale Signal entweder durch Multiplizieren des ersten digitalen Signals mit der verspäteten Nachbildung des zweiten digitalen Signals, oder durch Multiplizieren der verspäteten Nachbildung des ersten digitalen Signals mit dem zweiten digitalen Signal erhalten wird, und das vierte digitale Signal durch Multiplizieren des ersten digitalen Signals mit dem zweiten digitalen Signal erhalten wird;
      - eine digitale Tiefpassfilterung (FPB1, FPB2) auf das dritte und auf das vierte digitale Signal anzuwenden; und
      - die Phase ($\hat{\phi}$) der komplexen Impedanz des elektrischen Elements in Abhängigkeit von einem Verhältnis zwischen dem dritten ($m_n$) und dem vierten (md) gefilterten digitalen Signal und der Frequenz $f_{ex}$ des Anregungssignals durch Anwenden mindestens einer Nachschlagstabelle ($LUT_{DE}$, LUTA, LUTB) zu bestimmen.

8. Vorrichtung nach Anspruch 7, die auch einen Generator (GS) eines oszillierenden Anregungssignals ($S_{ex}$) umfasst, das eine sich im Inneren eines Spektralbandes gesteuert ändernde Oszillationsfrequenz $f_{ex}$ aufweist, wobei die Verzögerungsleitung (LR) konfiguriert ist, um eine Zeitverzögerung einzubringen, die konstant und gleich einem Viertel eines Zeitraums ist, der einer Frequenz entspricht, die in dem Spektralband beinhaltet ist.

9. Einrichtung nach Anspruch 8, wobei das Spektralband eine relative Breite $\Delta f/f_m$ aufweist, wobei $\Delta f$ die Abweichung zwischen der höchsten und der niedrigsten Frequenz des Bandes ist, und $f_m$ seine mittlere Frequenz, größer oder gleich 10% ist.

10. Vorrichtung nach einem der Ansprüche 7 bis 9, wobei die digitale Schaltung konfiguriert ist, um:

- einen ersten Winkelwert ($\hat{\varphi}$) durch Berechnen der Bogentangente des Verhältnisses zwischen dem dritten und vierten gefilterten digitalen Wert zu bestimmen; und
- die Phase der komplexen Impedanz des elektrischen Elements durch Anwenden einer zweieingängigen Nachschlagtabelle ($LUT_{DE}$), zu bestimmen, wobei die Eingänge der erste Winkelwert und die Frequenz $f_{ex}$ des Anregungssignals sind.

11. Vorrichtung nach einem der Ansprüche 7 bis 9, wobei die digitale Schaltung konfiguriert ist, um:

- einen ersten Zwischenwert, Summe des Verhältnisses zwischen dem dritten und vierten gefilterten digitalen Signals und eines ersten Korrekturbegriffs, der aus einer ersten Nachschlagtabelle (LUTA) in Abhängigkeit von der Frequenz $f_{ex}$ des Anregungssignals erhalten wird, zu berechnen;
- einen zweiten Zwischenwert, Produkt des ersten Zwischenwerts und eines zweiten Korrekturbegriffs, der aus einer zweiten Nachschlagtabelle (LUTB) in Abhängigkeit von der Frequenz $f_{ex}$ des Anregungssignals erhalten wird, zu berechnen; und
- die Phase der komplexen Impedanz des elektrischen Elements durch Berechnen der Bogentangente des zweiten Zwischenwerts zu bestimmen.

12. Vorrichtung nach einem der Ansprüche 7 bis 9, die auch einen Taktgenerator (H) umfasst, der konfiguriert ist, um den ersten und zweiten Analog-Digital-Wandler auf einen gleichen Erfassungs- und Umwandlungstakt des ersten und zweiten analogen Signals zu takten.

**Claims**

1. Method for measuring the phase of a complex impedance of an electric element (EL) comprising the following steps:

a) applying, to said electric element (EL), an excitation signal ($S_{ex}$) oscillating at a known frequency $f_{ex}$;
b) acquiring a first analogue signal ($u_v$), variable over time, representative of a voltage between two terminals of the electric element;
c) acquiring a second analogue signal ($u_i$), variable over time, representative of a current through the electric element;
d) sampling and converting to the digital format, the first and second analogue signal to obtain a first ($U_v$) and a second ($U_i$) digital signal;
e) generating a replica ($\hat{U}_i$), delayed by a determined time offset, of said first or of said second digital signal; **characterised in that** said method comprises the following steps:
f) calculating a third ($M_n$) and a fourth ($M_d$) digital signal, the third digital signal being obtained, either by multiplying the first digital signal by the delayed replica of the second digital signal, or by multiplying the delayed replica of the first digital signal by the second digital signal, and the fourth digital signal being obtained by multiplying the first digital signal by the second digital signal;
g) applying a low-pass digital filtering (FPB1, FPB2) to the third and to the fourth digital signal; and
h) determining said phase ($\hat{\varphi}$) of the complex impedance of the electric element as a function of a ratio between the third ($m_n$) and the fourth ($m_d$) filtered digital signals and of the frequency $f_{ex}$ of the excitation signal;

the step h) being implemented by application of at least one lookup table ($LUT_{DE}$, LUTA, LUTB).

2. Method according to claim 1, wherein the steps a) to h) are repeated a plurality of times for a plurality of frequencies $f_{ex}$ inside a spectral band, the time offset introduced during the step f) being constant and equal to a quarter of a period corresponding to a frequency included in said spectral band.

3. Method according to any one of the preceding claims, wherein said spectral band has a relative width $\Delta f/f_m$, where $\Delta f$ is the difference between the highest and the lowest frequency of the band and $f_m$ its average frequency, greater than or equal to 10%.

4. Method according to any one of the preceding claims, wherein the step h) comprises:

h1) determining a first angular value ($\hat{\varphi}_1$) by calculating the arc tangent of said ratio between the third and the fourth filtered digital signals; and

h2) determining said phase of the complex impedance of the electric element by application of a two-input lookup table ($LUT_{DE}$), the inputs being said first angular value and the frequency $f_{ex}$ of the excitation signal.

5. Method according to any one of claims 1 to 3, wherein the step h) comprises:

h1') calculating a first intermediate value, sum of said ratio between the third and the fourth filtered digital signals and a first correction term obtained from a first lookup table (LUTA) as a function of the frequency $f_{ex}$ of the excitation signal;

h2') calculating a second intermediate value, product of the first intermediate value and of a second correction term obtained from a second lookup table (LUTB) as a function of the frequency $f_{ex}$ of the excitation signal; and

h'3) determining said phase of the complex impedance of the electric element by calculating the arc tangent of said second intermediate value.

6. Method according to any one of the preceding claims, wherein, during the step d), the first and the second analogue signal are sampled and converted to the digital format at one same rate.

7. Apparatus for measuring the phase of a complex impedance of an electric element (EL) comprising:

- a first analogue-to-digital converter (ADC1) configured to receive an input of the first analogue signal ($u_v$), variable over time, representative of a voltage between two terminals of the electric element, and convert it into a first digital signal ($U_v$);
- a second analogue-to-digital converter (ADC2) configured to receive a second analogue signal ($u_i$), variable over time, representative of a current through the electric element, and convert it into a second digital signal ($U_v$);
- a delay line (LR) configured to generate a replica ($\hat{U}_i$), delayed by a determined time offset, of said first or of said second digital signal; **characterised in that** said measuring apparatus comprises
- a digital circuit configured to:

- calculating a third ($M_n$) and a fourth ($M_d$) digital signal, the third digital signal being obtained, either by multiplying the first digital signal by the delayed replica of the second digital signal, or by multiplying the delayed replica of the first digital signal by the second digital signal, and the fourth digital signal being obtained by multiplying the first digital signal by the second digital signal;
- applying a low-pass digital filtering (FPB1, FPB2) to the third and to the fourth digital signal; and
- determining said phase ($\hat{\varphi}$) of the complex impedance of the electric element as a function of a ratio between the third ($m_n$) and the fourth (md) filtered digital signals and of the frequency $f_{ex}$ of the excitation signal by application of at least one lookup table ($LUT_{DE}$, LUTA, LUTB).

8. Apparatus according to claim 7, also comprising a generator (GS) of an oscillating excitation signal ($S_{ex}$) having a variable oscillation frequency $f_{ex}$ in a controlled manner inside a spectral band, wherein said delay line (LR) is configured to introduce a constant time offset and equal to a quarter of a period corresponding to a frequency included in said spectral band.

9. Apparatus according to claim 8, wherein said spectral band has a relative width $\Delta f/f_m$, where $\Delta f$ is the difference between the highest and the lowest frequency of the band and $f_m$ its average frequency, greater than or equal to 10%.

10. Apparatus according to any one of claims 7 to 9, wherein the digital circuit is configured to:

- determine a first angular value ($\widehat{\varphi_1}$) by calculating the arc tangent of said ratio between the third and the fourth filtered digital signals; and
- determine said phase of the complex impedance of the electric element by application of a two-input lookup table ($LUT_{DE}$), the inputs being said first angular value and the frequency $f_{ex}$ of the excitation signal.

11. Apparatus according to any one of claims 7 to 9, wherein the digital circuit is configured to:

- calculate a first intermediate value, sum of said ratio between the third and the fourth filtered digital signals and a first correction term obtained from a first lookup table (LUTA) as a function of the frequency $f_{ex}$ of the excitation

signal;
- calculate a second intermediate value, product of the first intermediate value and of a second correction term obtained from a second lookup table (LUTB) as a function of the frequency $f_{ex}$ of the excitation signal; and
- determine said phase of the complex impedance of the electric element by calculating the arc tangent of said second intermediate value.

12. Apparatus according to any one of claims 7 to 9, also comprising a clock (H) configured to pace said first and second analogue-to-digital converters at one same acquisition rate and conversion of said first and second analogue signals.

[Fig. 1]

Fig. 1

[Fig. 2]

Fig. 2

[Fig. 3]

Fig. 3

[Fig. 4]

Fig. 4

[Fig. 5]

| $f$<br>$\hat{\varphi}_1$ | F0 | F1 | F2 | $\cdots$ | FN-3 | FN-2 | FN-1 |
|---|---|---|---|---|---|---|---|
| Φ0 | $\Phi_{cmp(0,0)}$ | $\Phi_{cmp(1,0)}$ | $\Phi_{cmp(2,0)}$ | $\cdots$ | $\Phi_{cmp(N-3,0)}$ | $\Phi_{cmp(N-2,0)}$ | $\Phi_{cmp(N-1,0)}$ |
| Φ1 | $\Phi_{cmp(0,1)}$ | $\Phi_{cmp(1,1)}$ | $\Phi_{cmp(2,1)}$ | $\cdots$ | $\Phi_{cmp(N-3,1)}$ | $\Phi_{cmp(N-2,1)}$ | $\Phi_{cmp(N-1,1)}$ |
| Φ2 | $\Phi_{cmp(0,2)}$ | $\Phi_{cmp(1,2)}$ | $\Phi_{cmp(2,2)}$ | $\cdots$ | $\Phi_{cmp(N-3,2)}$ | $\Phi_{cmp(N-2,2)}$ | $\Phi_{cmp(N-1,2)}$ |
| $\cdots$ | $\cdots$ | $\cdots$ | $\cdots$ | $\cdots$ | $\cdots$ | $\cdots$ | $\cdots$ |
| ΦN-3 | $\Phi_{cmp(0,N-2)}$ | $\Phi_{cmp(1,N-3)}$ | $\Phi_{cmp(2,N-3)}$ | $\cdots$ | $\Phi_{cmp(N-3,N-3)}$ | $\Phi_{cmp(N-2,N-3)}$ | $\Phi_{cmp(N-1,N-3)}$ |
| ΦN-2 | $\Phi_{cmp(0,N-2)}$ | $\Phi_{cmp(1,N-2)}$ | $\Phi_{cmp(2,N-2)}$ | $\cdots$ | $\Phi_{cmp(N-3,N-2)}$ | $\Phi_{cmp(N-2,N-2)}$ | $\Phi_{cmp(N-1,N-2)}$ |
| ΦN-1 | $\Phi_{cmp(0,N-1)}$ | $\Phi_{cmp(1,N-1)}$ | $\Phi_{cmp(2,N-1)}$ | $\cdots$ | $\Phi_{cmp(N-3,N-1)}$ | $\Phi_{cmp(N-2,N-1)}$ | $\Phi_{cmp(N-1,N-1)}$ |

Fig. 5

[Fig. 6]

Fig. 6

[Fig. 7]

Fig. 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2020150164 A1

**Littérature non-brevet citée dans la description**

- **L. ANGRISANI** ; **L. FERRIGNO**. Reducing the uncertainty in real-time impedance measurements. *Measurement*, 2001, vol. 30 (4), 307-315

- **JENS SCHRÖDER** ; **STEFFEN DOERNER** ; **THOMAS SCHNEIDER** ; **PETER HAUPTMANN**. Analogue and digital sensor interfaces for impedance spectroscopy. *Measurement Science and Technology*, 2004, vol. 15 (7), 1271-1278